# EUROPEAN PATENT APPLICATION

(11) **EP 2 849 241 A1**
(43) Date of publication of application: **18.03.2015**
(21) Application number: 14184320.1
(22) Date of filing: 10.09.2014
(51) Int. Cl.: H01L 51/00, C07F 7/08, H01L 27/12, B32B 7/06

(54) **Method for manufacturing display panel**

(30) Priority: 10.09.2013 KR 20130108622
(71) Applicant: Samsung Display Co., Ltd., Gyeonggi-Do (KR)
(72) Inventor: Kim, Tae Woong, Gyeonggi-do (KR); Kim, Hyung Sik, Gyeonggi-do (KR); Koo, Hyun Woo, Gyeonggi-do (KR); Jang, Woo Jeong, Gyeonggi-do (KR); Lee, Ki-Yong, Chungcheongnam-do (KR)
(74) Representative: Mounteney, Simon James

(57) **Abstract**

A method of manufacturing a display panel is provided. A release layer is formed on a support substrate. A thin film substrate is formed on the release layer and the support substrate. A pixel and an encapsulation member are formed on a part of the thin film substrate. The part of the thin film substrate is overlapped with the release layer. The part of the thin film substrate is separated from the support substrate. The release layer includes siloxane and polyimide silane.

## Description

### TECHNICAL FIELD

The present invention relates to a display panel and a method for manufacturing the same.

### DISCUSSION OF THE RELATED ART

Organic light emitting diode (OLED) displays are self-light emitting displays. OLED displays do not require a separate light source, and thus are thin and lightweight.

OLED displays may be formed on various substrates. For example, a glass substrate may be used. For a flexible display device, a flexible substrate such as a polymer substrate or an ultra-thin film glass may be used. For example, OLED displays may be formed on a polymer substrate instead of a glass substrate. Alternatively, OLED displays may be formed on an ultra-thin film glass substrate.

Typically the substrate is formed as a thin-film substrate on a support substrate during manufacture. One problem with this technique is that the two substrates need to be separated by laser ablation and this degrades the transparency of the thin film.

### SUMMARY

The present invention sets-out to provide a method of manufacturing a display panel in which the transparency of the thin film substrate is preserved.

According to an embodiment of the present invention, a method for manufacturing a display panel is provided. A release layer is formed on a support substrate. A thin film substrate is formed on the release layer and the support substrate. A pixel and an encapsulation member are formed on a part of the thin film substrate. The part of the thin film substrate is overlapped with the release layer. The part of the thin film substrate is separated from the support substrate. The release layer includes siloxane and polyimide silane.

According to an embodiment of the present invention, a method for manufacturing a display panel is provided. A plurality of release layers is formed on a support substrate in a matrix form. A thin film substrate is formed on the support substrate, covering the pluarlity of release layers. The thin film substrate is in contact with the release layer and the support substrate. A plurality of pixels is formed on the thin film substrate. Each pixel is disposed on a part of the thin film substrate. The part of the thin film substrate is overlapped with each release layer. Each pixel is cut along a perimeter of a region where each release layer is interposed between the thin film substrate and the support substrate. Each pixel is separated from the support substrate to form a display panel. The release layer includes siloxane and polyimide silane.

At least some of the above and other features of the invention are set-out in the claims.

### BRIEF DESCRIPTION OF THE DRAWINGS

These and other features of the present invention will be made more apparent by describing embodiments thereof with reference to the accompanying drawings of which:
FIG. 1 is a flowchart showing a method for manufacturing a display device according to an embodiment of the present invention.
FIGS. 2 to 5 are cross-sectional views showing a method for manufacturing a display panel according to an embodiment of the present invention.
FIG. 6 is a graph showing adherence of a release layer according to an embodiment of the present invetion.
FIG. 7 is a layout of a display panel formed on a mother substrate according to an embodiment of the present invention.
FIG. 8 is a layout of an organic light emitting panel according to an embodiment of the present invention.
FIG. 9 is a pixel circuit of an organic light emitting display panel according to an embodiment of the present invention.
FIG. 10 is a pixel circuit of an organic light emitting display panel according to an embodiment of the present invention.
FIG. 11 is a cross-sectional view of one pixel of an organic light emitting display panel of FIG. 9, according to an embodiment of the present invention.
FIGS. 12 to 16 are cross-sectional views showing a method for manufacturing one pixel of an organic light emitting display panel according to an embodiment of the present invention.

### DETAILED DESCRIPTION OF THE EMBODIMENTS

Embodiments of the present invention will be described below in detail with reference to the accompanying drawings. However, the present invention may be embodied in different forms and should not be construed as limited to the embodiments set forth herein. In the drawings, the thickness of layers and regions may be exaggerated for clarity. It will also be understood that when an element is referred to as being "on" another element or substrate, it may be directly on the other element or substrate, or intervening layers may also be present. It will also be understood that when an element is referred to as being "coupled to" or "connected to" another element, it may be directly coupled to or connected to the other element, or intervening elements may also be present. Like reference numerals may refer to the like elements throughout the specification and drawings.

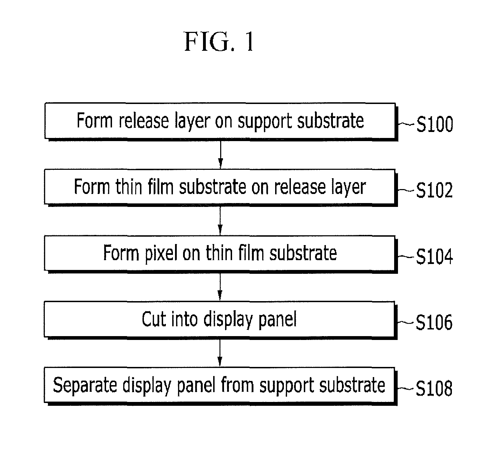

FIG. 1 is a flowchart showing a method for manufacturing a display panel according to an embodiment of the invention.

As shown in FIG. 1, the method for manufacturing a display panel according to the present invention includes forming a release layer on a support substrate (S100), forming a thin film substrate on the release layer (S102), forming a pixel including a thin film transistor on the thin film substrate (S104), cutting into the display panel (S106), and separating the display panel from the support substrate (S108).

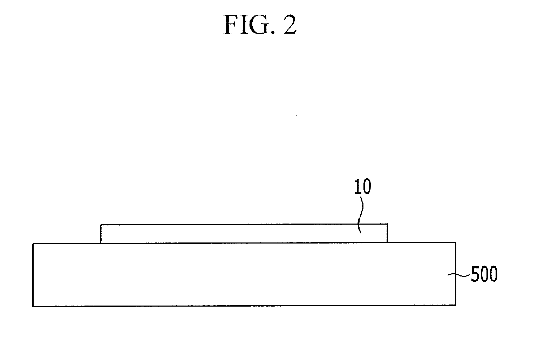

Hereinafter, the method for manufacturing the display panel according to the flowchart of FIG. 1 will be described in detail with reference to FIGS. 2 to 7.

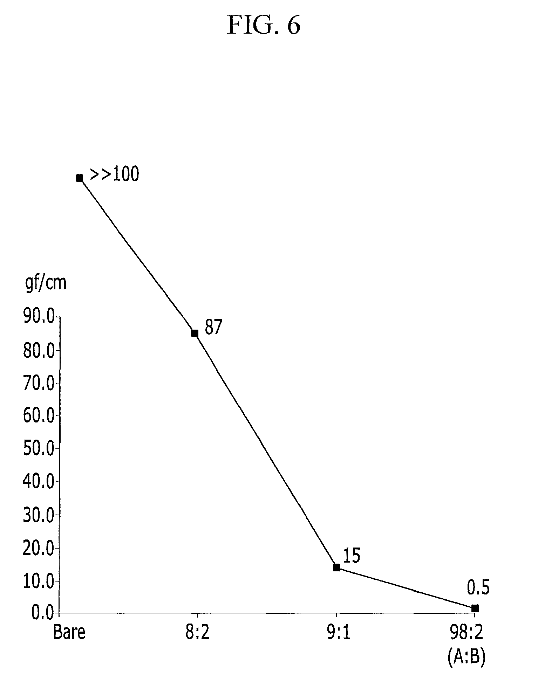

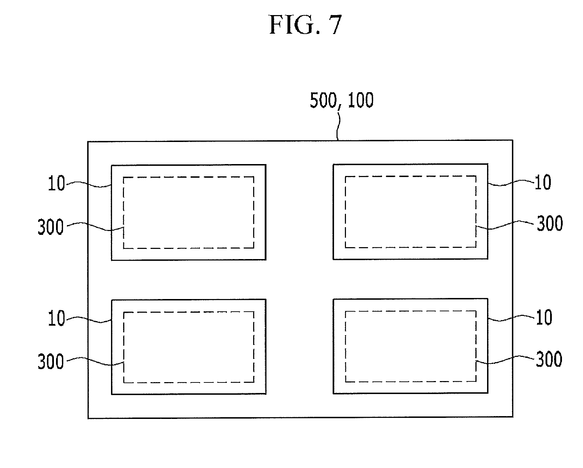

FIGS. 2 to 5 are schematic cross-sectional views showing the method for manufacturing a display panel according to an embodiment of the invention. FIG. 6 is a graph obtained by measuring adherence according to a ratio of glassy silicone and polyimide silane according to the embodiment. FIG. 7 is a layout of a display panel formed on a thin film substrate 100 according to the embodiment of FIGS. 2 to 5.

As shown in FIG. 2, a support substrate 500 is prepared, and a release layer 10 is formed on the support substrate 500 (S100).

The support substrate 500 may be formed of a glass substrate. The support substrate serves to support a thin film substrate to be formed and prevent such thin film substrate from being bent due to due to its small thickness.

The release layer 10 serves to separate the thin film substrate from the support substrate 500. The release layer 10 may be formed by applying a solution process and then performing curing.

The release layer 10 is formed by applying a solution where siloxane and polyimide silane are mixed at a weight ratio of about 8 : about 2 to about 98 : about 2.

Siloxane includes oxygen and silicon, and may include, for example, glassy silicone.

Referring to FIG. 6, when glassy silicone and polyimide silane are mixed in an amount of less than 8:2, adherence between the thin film substrate 100 and the support substrate 500 is more than 87 gf/cm, and thus the mother substrate and the PI substrate are not easily separated. When glassy silicone and polyimide silane are mixed in an amount of more than 98:2, adherence is less than 0.5 gf/cm, so the support substrate 500 substrate and the thin film substrate 100 may be unintentionally separated during a process.

The release layer 10 is formed in a thickness of about 100 Å to about 10,000 Å. When the thickness of the release layer is less than 100 Å, separation is not easily performed, and when the thickness is more than 10,000 Å, productivity is reduced. Accordingly, the release layer is formed in a thickness in the range of about 100 Åto 10,000 Å.

The solution inlcudes a solvent in addition to glassy silicone and polyimide silane. For example, the solvent may include PGMEA (propylene glycol monomethyl ether acetate), PGME (propylene glycol monomethyl ether), MMP (methyl beta methoxypropionate), or EEP (ethyl ethoxylpropionate).

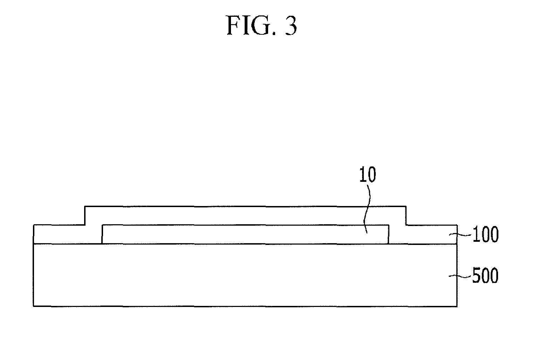

Next, as shown in FIG. 3, a thin film substrate 100 is formed on the release layer 10 and the support substrate 500.

In this case, the thin film substrate 100 is in contact with the release layer 10 and the support substrate 500. Adherence between the support substrate 500 and the thin film substrate 100 is stronger than adherence between the release layer 10 and the thin film substrate 100. The adherence between the support substrate 500 and the thin film substrate 100 is such that the thin film substrate is not separated during a process for manufacturing a display panel.

The thin film substrate 100 may include a flexible polymer substrate formed of a polymer material, or a flexible ultra-thin film glass substrate.

The flexible ultra-thin film glass substrate has a thickness of about 50 µm to about 200 µm. While a subsequent process is performed, the thin film substrate 100 is supported on the support substrate 500.

The thin film substrate 100, as shown in FIG. 7, may be a mother substrate where a plurality of display panels 300 including a pixel, such as an organic light emitting display panel or a liquid crystal display panel, are formed simultaneously. In this case, the display panels 300 are formed in plural on the mother substrate, and then separated into individual display panels. In this case, when the release layer 10 is formed on the entire substrate, a substrate stripping phenomenon may occur. Accordingly, the release layer is formed only in a region where the display panel 300 is formed.

Accordingly, a plurality of release layers are formed in the same number as the display panels to be formed on the mother substrate. The release layers 10 may form a matrix on the support substrate 500. The display panel is formed in a boundary line of the release layer.

When the thin film substrate 100 is the polymer substrate, the thin film substrate may be formed by a method for applying the liquid polymer material on the release layer and then thermally curing the liquid polymer material.

The polymer substrate may be applied by a method such as spin coating or nozzle printing. If necessary, application and curing processes may be repeatedly performed, and a buffer layer such as silicon oxide or silicon nitride may be further formed between the polymer substrates.

As the polymer material, polyimide, polycarbonate, polyacrylate, polyetherimide, polyethersulfone, polyethylene terephthalate, and polyethylene naphthalate may be used. Among the polymer materials, polyimide is usable at a high process temperature of 450 °C. Therefore, a reduction in properties of the thin film transistor may be minimized when the thin film transistor is manufactured.

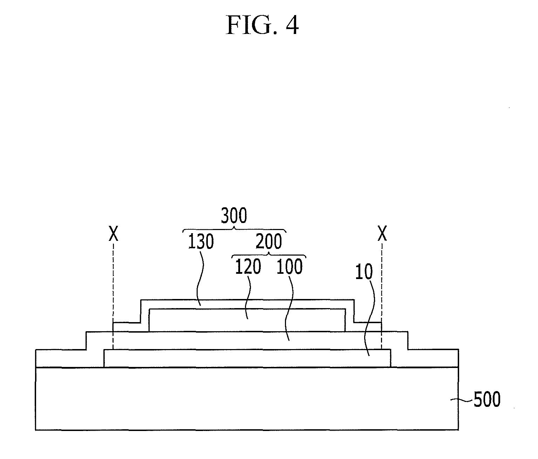

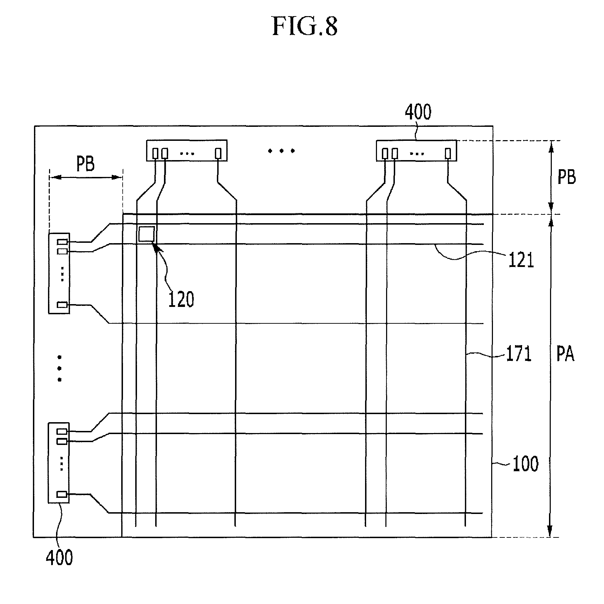

Next, as shown in FIG. 4, a plurality of pixels 120 is formed on the thin film substrate 100. The plurality of pixels 120 is arranged in a matrix as shown in FIG. 8.

FIG. 8 is a layout of an organic light emitting panel according to an embodiment of the invention.

Referring to FIG. 8, the organic light emitting panel includes a display unit PA and a driver PB formed on the thin film substrate 100. The display unit PA includes a plurality of pixels 120, and the driver PB includes a driving circuit connected to the plurality of pixels 120.

The display unit PA further includes a first signal line 121 extended in a first direction to transfer a scan signal to a respective pixel 120. The dsplay unit PA further includes a second signal line 171 crossing the first signal line 121 to transfer a video signal to a respective pixel. Each pixel 120 is connected to the first signal line 121 and the second signal line 171 to display an image. The display unit PA may further include various signal lines to provide other signals to a repective pixel 120.

Each pixel 120, displaying an image, includes a thin film transistor and an organic light emitting diode operating in response to the scan signal and the video signal from the first signal line 121 and the second signal line 171.

The organic light emitting diode is controlled by the driver, and emits light according to a driving signal to display an image.

The driver PB includes a driver 400 connected to the first signal line 121 or the second signal line 171 to transfer an external signal. The driver 400 may be mounted as an IC chip on the thin film substrate, or integrated together with the thin film transistor of the display unit on the thin film substrate.

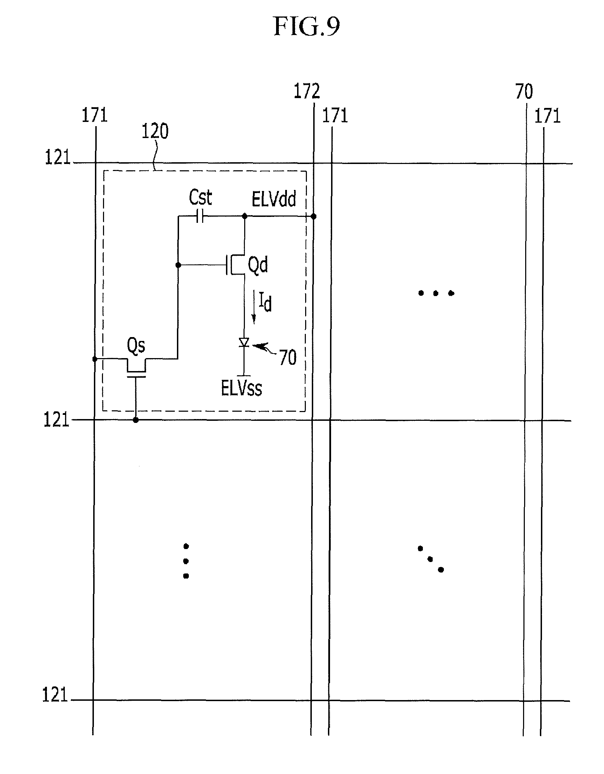

Referring to FIG. 9, the pixel of the organic light emitting display panel will be more specifically described.

FIG. 9 is a pixel circuit of an organic light emitting substrate according to an embodiment of the invention.

As shown in FIG. 9, the display panel according to this embodiment includes a plurality of signal lines 121, 171, and 172 and a plurality of pixels 120 connected thereto and arranged in a matrix form.

The first signal line 121 may be a gate line transferring a gate signal (or scan signal), the second signal line 171 may be a data line transferring a data signal (or video signal), and the third signal line 172 may be a driving voltage line transferring a driving voltage Vdd.

The first signal lines 121 extend in a first direction in parallel to each other, crossing the second signal lines 171 and the third signal lines 172.

Each pixel 120 includes a switching thin film transistor Qs, a driving thin film transistor Qd, a storage capacitor Cst, and an organic light emitting diode (OLED) 70.

The switching thin film transistor Qs has a control terminal, an input terminal, and an output terminal. The control terminal is connected to the first signal line 121, the input terminal is connected to the second signal line 171, and the output terminal is connected to the driving thin film transistor Qd. The switching thin film transistor Qs responds to a scan signal applied to the first signal line 121 to transfer a data signal applied to the second signal line 171 to the driving thin film transistor Qd.

Further, the driving thin film transistor Qd has a control terminal, an input terminal, and an output terminal. The control terminal is connected to the switching thin film transistor Qs, the input terminal is connected to the third signal line 172, and the output terminal is connected to the organic light emitting diode 70. The driving thin film transistor Qd supplies an output current Id to the organic light emitting diode 70. The magnitude of the output current Id may vary according to a voltage applied between the control terminal and the output terminal of the driving thin film transistor Qd.

The capacitor Cst is connected between the control terminal and the input terminal of the driving thin film transistor Qd. The capacitor Cst is further connected to the output terminal of the swiching thin film transistor Qs. The capacitor Cst charges the data signal applied to the control terminal of the driving thin film transistor Qd and maintains the data signal even after the switching thin film transistor Qs is turned off.

The organic light emitting diode 70 has an anode connected to the output terminal of the driving thin film transistor Qd, and a cathode connected to a common voltage Vss. The organic light emitting diode 70 emits light whose intensity is changed according to the output current Id of the driving thin film transistor Qd to display the image.

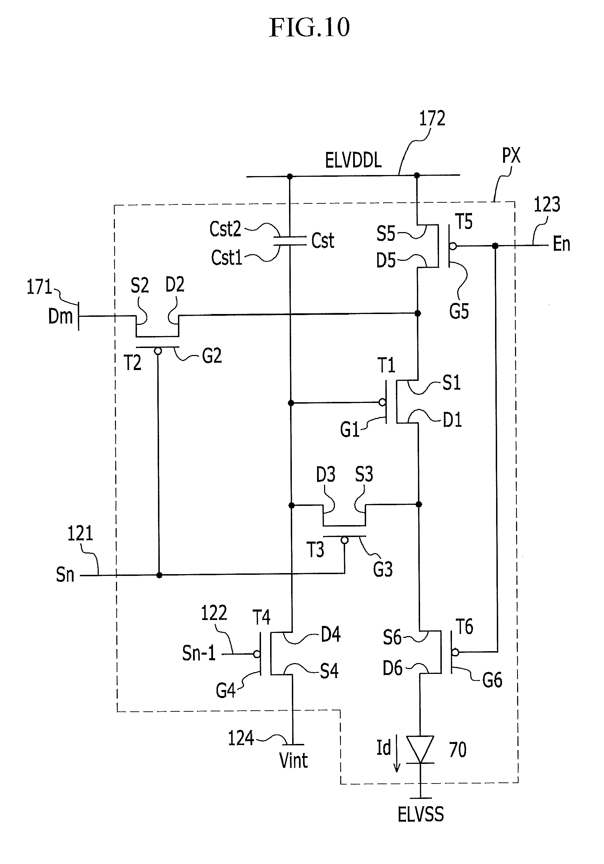

Further, a connection relationship of the thin film transistors Qs and Qd, the capacitor Cst, and the organic light emitting diode OLED may be changed as shown in FIG. 10, but is not limited thereto.

FIG. 10 is a pixel circuit of an organic light emitting display panel according to an embodiment of the invention.

As shown in FIG. 10, one pixel 120 of the organic light emitting display panel according to this embodiment includes a plurality of signal lines 121, 122, 123, 124, 171, and 172, and a plurality of thin film transistors T1, T2, T3, T4, T5, and T6, a storage capacitor Cst, and an organic light emitting diode 70 connected to the plurality of signal lines.

The transistor includes a driving transistor (driving thin film transistor), a switching transistor (switching thin film transistor), a compensation transistor, an initialization transistor, an operation control transistor, and a light emission control transistor.

Hereinafter, for the convenience of description, the driving transistor is called a first transistor T1, the switching transistor is called a second transistor T2, the compensation transistor is called a third transistor T3, the initialization transistor is called a fourth transistor T4, the operation control transistor is called a fifth transistor T5, and the light emission control transistor is called a sixth transistor T6.

The signal lines includes a gate line 121 transferring a scan signal Sn to the third transistor T3, a prior gate line 122 transferring a prior scan signal Sn-1 to the fourth transistor T4, a light emission control line 123 transferring a light emission control signal En to the fifth thin film transistor T5 and the sixth thin film transistor T6, a data line 171 crossing the gate line 121 and transferring a data signal Dm to the second transistor T2, a driving voltage line 172 transferring a driving voltage ELVDD and formed almost parallel to the data line 171, and an initialization voltage line 124 transferring an initialization voltage Vint initializing the first transistor T1.

A first gate electrode G1 of the first transistor T1 is connected to an end Cst1 of a storage capacitor Cst, a first source electrode S1 thereof is connected to the driving voltage line 172 via the fifth transistor T5, and a drain electrode D1 thereof is electrically connected to the anode of the organic light emitting diode 70 via the sixth transistor T6. The first transistor T1 receives the data signal Dm according to a switching operation of the second transistor T2 to supply a driving current I_{d} to the organic light emitting diode 70.

A second gate electrode G2 of the second transistor T2 is connected to the gate line 121, a second source electrode S2 thereof is connected to the data line 171, and a second drain electrode D2 is connected to the first source electrode S1 of the first transistor T1 and to the driving voltage line 172 via the fifth transistor T5. The second transistor T2 is turned on according to the scan signal Sn transferred through the gate line 121 to perform a switching operation for transferring the data signal Dm transferred to the data line 171 to the first source electrode S1 of the first transistor T1.

A third gate electrode G3 of the third transistor T3 is connected to the gate line 121, and a third source electrode S3 is connected to the first drain electrode D1 of the first transistor T1 and to the anode of the organic light emitting diode 70 via the sixth transistor T6. A third drain electrode D3 is connected to the end Cst1 of the storage capacitor Cst, a fourth drain electrode D4 of the fourth transistor T4, and the first gate electrode G1 of the first transistor T1 together. The third transistor T3 is turned on according to the scan signal Sn transferred through the gate line 121 to connect the gate electrode G1 and the drain electrode D1 of the first transistor T1 to each other, thereby forming a diode-connection of the first transistor T1.

A fourth gate electrode G4 of the fourth transistor T4 is connected to the prior gate line 122, a fourth source electrode S4 thereof is connected to the initialization voltage line 124, and a fourth drain electrode D4 thereof is connected to the end Cst1 of the storage capacitor Cst, the third drain electrode D3 of the third transistor T3, and the first gate electrode G1 of the first transistor T1 together. The fourth transistor T4 is turned on according to the prior scan signal Sn-1 transferred through the prior gate line 122 to transfer the initialization voltage Vint to the first gate electrode G1 of the first transistor T1, thus performing an initialization operation where the voltage of the first gate electrode G1 of the first transistor T1 is initialized to the initialization voltage Vint.

A fifth gate electrode G5 of the fifth transistor T5 is connected to the light emission control line 123, a fifth source electrode S5 of the fifth transistor T5 is connected to the driving voltage line 172, and a fifth drain electrode D5 of the fifth transistor T5 is connected to the first source electrode S1 of the first transistor T1 and the second drain electrode D2 of the second transistor T2.

A sixth gate electrode G6 of the sixth transistor T6 is connected to the light emission control line 123, a sixth source electrode S6 of the sixth transistor T6 is connected to the first drain electrode D1 of the first transistor T1 and the third source electrode S3 of the third transistor T3, and a sixth drain electrode D6 of the sixth transistor T6 is electrically connected to the anode of the organic light emitting diode 70. The fifth transistor T5 and the sixth transistor T6 are simultaneously turned on according to the light emission control signal En transferred through the light emission control line 123 to transfer the driving voltage ELVDD to the organic light emitting diode 70, thus allowing the driving current I_{d} to flow through the organic light emitting diode 70.

Another end Cst2 of the storage capacitor Cst is connected to the driving voltage line 172, and the cathode of the organic light emitting diode 70 is connected to a common voltage ELVSS. Accordingly, the organic light emitting diode 70 receives the driving current I_{d} from the first transistor T1 to emit light, thereby displaying an image.

The first transistor T1 charges a voltage corresponding to the data signal Dm in the storage capacitor Cst according to the scan signal Sn, and provides a current corresponding to the voltage charged in the storage capacitor Cst to the organic light emitting diode 70. In this case, a threshold voltage of the first transistor T1 may be changed as time passes. Accordingly, the third transistor T3 is connected to the first transistor T1 by a diode structure according to the scan signal Sn to compensate a threshold voltage Vth.

Hereinafter, an operation of the pixel circuit of FIG. 10 will be described in detail.

First, the prior scan signal Sn-1 having a low level is supplied through the prior gate line 122 during an initialization period. In response to the prior scan signal, the fourth transistor T4 is turned on, and the initialization voltage Vint is supplied from the initialization voltage line 124 through the fourth transistor T4 to the first gate electrode of the first transistor T1. The first gate electrode of the first transistor T1 is initialized with the initialization voltage Vint.

Thereafter, the scan signal Sn having a low level is supplied through the gate line 121 during a data programming period. In response to the scan signal Sn, the second transistor T2 and the third transistor T3 are turned on. The first transistor T1 is diode-connected by the turned-on third transistor T3, and is biased in a forward direction.

Then, a compensation voltage Dm+Vth is applied to the first gate electrode of the first transistor T1 to prevent a threshold voltage drop across the driving transistor T1. The Vth is a threshold voltage of the driving transistor T1 and has a negative voltage.

The driving voltage ELVDD and the compensation voltage Dm+Vth are applied to both ends of the storage capacitor Cst. The voltage difference of the driving voltage ELVDD and the compensation voltage Dm+Vth is stored in the storage capacitor Cst. Thereafter, the level of the light emission control signal En supplied from the light emission control line 123 during a light emission period is changed from the high level to the low level. Then, the fifth transistor T5 and the sixth transistor T6 are turned on by the light emission control signal En having the low level during the light emission period.

Then, the driving current Id corresponds to a voltage difference between the voltage of the first gate electrode G1 of the first transistor T1 and the driving voltage ELVDD. The driving current Id is supplied through the sixth transistor T6 to the organic light emitting diode 70. A gate-source voltage Vgs of the first transistor T1 is maintained at "(Dm+Vth)-ELVDD" by the storage capacitor Cst during the light emission period. The driving current Id is proportional to a square of a value obtained by subtracting the threshold voltage from a source-gate voltage, that is, "(Dm-ELVDD)²", according to a current-voltage relationship of the first transistor T1. Accordingly, the driving current Id is determined regardless of the threshold voltage Vth of the driving transistor T1.

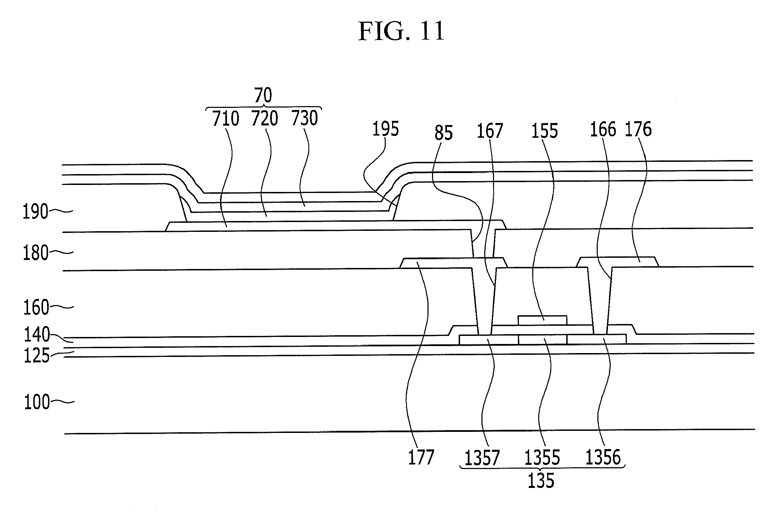

Now, the physical structure of the pixel circuit in FIG. 10 will be described with reference to FIG. 11.

Referring to FIG. 11, the driving transistor T1 will be described. Other transistors including the switching transistor T2 may include a cross-sectional structure substantially similar to that of the driving transistor T1.

The physical structure of the pixel circuit includes a buffer layer 125 positioned on the thin film substrate 100 and a semiconductor 135 positioned on the buffer layer 125.

The buffer layer 125 may be formed of a single layer having a silicon oxide (SiOₓ) or a silicon nitride (SiNx). Alternatively, the buffer layer 125 may include a plurality of layers where a silicon nitride (SiNx) and a silicon oxide (SiOₓ) are laminated. The buffer layer 125 serves to block unnecessary components such as an impurity or moisture from the substrate 100, and provides a planar surface for a subsequent process.

The semiconductor 135 may be formed of polysilicon. The semiconductor 135 is formed on the buffer layer 125. The semiconductor 135 may have a thickness of about 450 Å or more.

The semiconductor 135 is divided into a channel region 1355, and a source region 1356 and a drain region 1357 formed at respective sides of the channel region 1355. The channel region 1355 of the semiconductor 135 is polysilicon not doped with the impurity, that is, an intrinsic semiconductor. The source region 1356 and the drain region 1357 of the semiconductor 135 are polysilicon doped with a conductive impurity.

The impurity may include a p-type impurity or an n-type impurity.

A gate insulating layer 140 is formed on the semiconductor 135. The gate insulating layer 140 may be a single layer or a plurality of layers including at least one of tetraethoxysilane (TEOS), a silicon nitride, and a silicon oxide.

A gate electrode 155 is formed on the gate insulating layer 140.

The gate electrode 155 may be formed of a single layer. Alternatively, the gate electrode 155 may include a plurality of layers of a low resistance material such as Al, Ti, Mo, Cu, Ni, or an alloy thereof, or a material having strong corrosion resistance. For example, the gate electrode may be formed of a triple layer of Ti/Cu/Ti, Ti/Ag/Ti, or

Mo/Al/Mo.

A first interlayer insulating layer 160 is formed on the gate electrode 155.

The first interlayer insulating layer 160 may be formed of a single layer or a plurality of layers of tetraethoxysilane (TEOS), a silicon nitride, or a silicon oxide. The silicon oxide may be similar to a material of the gate insulating layer 140.

A source electrode 176 and a drain electrode 177 are formed on the first interlayer insulating layer 160. The source electrode 176 and the drain electrode 177 are connected through contact holes 166 and 167 to the source region 1356 and the drain region 1357, respectively.

The source electrode 176 and the drain electrode 177 may be formed of a single layer or a plurality of layers of a low resistance material such as Al, Ti, Mo, Cu, Ni, or an alloy thereof, or a material having strong corrosion resistance. For example, the source electrode and the drain electrode may be a triple layer of Ti/Cu/Ti, Ti/Ag/Ti, or Mo/Al/Mo.

A thin film transistor (TFT) includes the gate electrode 155, the source electrode 176, the drain electrode 177, and the semiconductor 135. A channel of the thin film transistor is formed in the semiconductor 135 between the source electrode 176 and the drain electrode 177.

A second interlayer insulating layer 180 is formed on the source electrode 176 and the drain electrode 177.

The second interlayer insulating layer 180 may be formed of a single layer or a plurality of layers of tetraethoxysilane (TEOS), a silicon nitride, or a silicon oxide. The silicon oxide may be similar to a material of the first interlayer insulating layer.

A first electrode 710 is formed on the second interlayer insulating layer 180. The first electrode 710 may be an anode electrode of the organic light emitting diode of FIG. 9.

The drain electrode 177 and the first electrode 710 are connected through the contact holes 167 and 85 while the second interlayer insulating layer 180 is interposed therebetween. However, the drain electrode 177 and the first electrode 710 may be integrally formed.

A pixel definition layer 190 having an opening 195 through which the first electrode 710 is exposed is formed on the second interlayer insulating layer 180.

The pixel definition layer 190 may be formed to include resins such as polyacrylates or polyimides, and silica-based inorganic materials.

An organic emission layer 720 is formed on the first electrode 710 of the opening 195.

The organic emission layer 720 may be formed of a low molecular organic material or a high molecular organic material such as PEDOT (poly)3,4-ethylenedioxythiophene)). Further, the organic emission layer 720 may be formed of a multilayer including a hole injection layer (HIL), a hole transport layer (HTL), an electron transport layer (ETL), an electron injection layer (EIL), or the emission layer. When the organic emission layer 720 includes all the layers, the hole injection layer (HIL) is disposed on the first electrode 710 as the anode, and the hole transport layer (HTL), the emission layer, the electron transport layer (ETL), and the electron injection layer (EIL) are sequentially laminated thereon.

In the organic emission layer 720, a red organic emission layer, a green organic emission layer, and a blue organic emission layer may be laminated in a red pixel, a green pixel, and a blue pixel, respectively, and a red color filter, a green color filter, and a blue color filter may be formed for each pixel to embody a color image. As another example, a white organic emission layer emitting light having a white color may be formed in all of the red pixel, the green pixel, and the blue pixel, and the red color filter, the green color filter, and the blue color filter may be formed for each pixel to embody the color image.

In the organic emission layer 720, the lamination structures of the red pixel, the blue pixel, and the green pixel are substantially the same as each other. Accordingly, a single deposition mask may be used for depositing the organic emission layer on each pixel including the red pixel, the green pixel, and the blue pixel.

The white organic emission layer may be formed of one organic emission layer or a plurality of organic emission layers to emit light having the white color. For example, the white organic emission layer may include at least one yellow organic emission layer and at least one blue organic emission layer to emit light having the white color. Alternatively, the white organic emission layer may include at least one cyan organic emission layer and at least one red organic emission layer to emit light having the white color. Alternatively, the white organic emission layer may include at least one magenta organic emission layer and at least one green organic emission layer to emit light having the white color.

Now, a method for manufacturing the organic light emitting display panel will be described with reference to FIGS. 11 to 16.

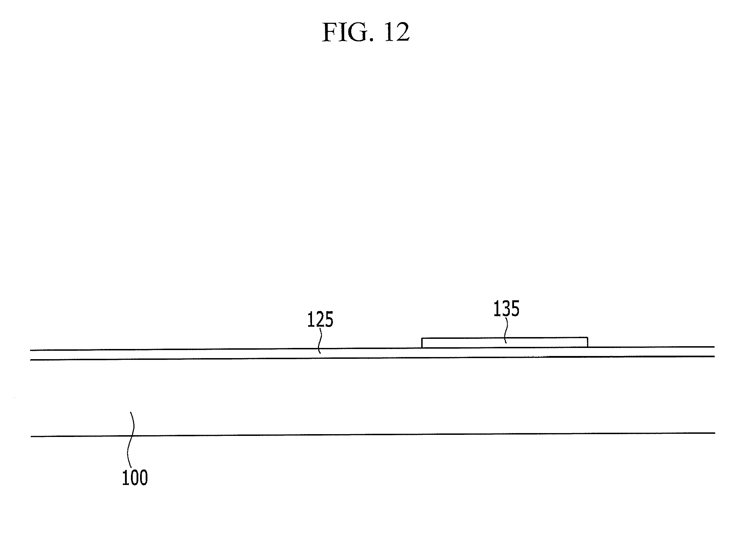

FIGS. 12 to 16 are cross-sectional views showing a method for manufacturing one pixel of one organic light emitting display panel according to an embodiment of the invention.

First, as shown in FIG. 12, the buffer layer 125 is formed on the thin film substrate 100. The buffer layer 125 may be formed of a silicon nitride or a silicon oxide.

After an amorphous silicon film is formed on the buffer layer 125, a dehydrogenation process is performed.

The dehydrogenation process reduces the amount of hydrogen included in the amorphous silicon film to prevent a film breakage phenomenon due to hydrogen during a subsequent process. The dehydrogenation process is performed at a temperature of about 450 °C for about 1 hour.

Thereafter, the amorphous silicon film is crystallized by an Excimer Laser Annealing (ELA) process to form a polysilicon film.

After that, the polysilicon film is patterned to form the semiconductor 135.

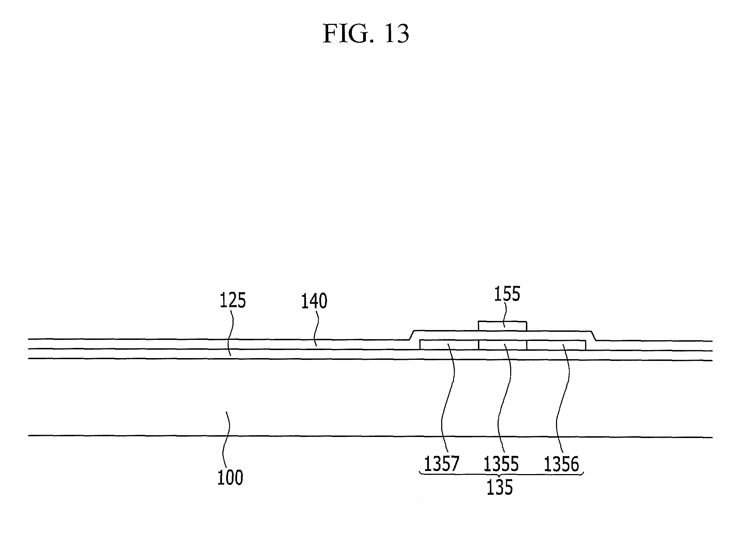

Next, as shown in FIG. 13, the gate insulating layer 140 is formed on the semiconductor 135. The gate insulating layer 140 may be formed of a silicon nitride or a silicon oxide.

In addition, a metal film is laminated on the gate insulating layer 140 and then patterned to form the gate electrode 155.

The conductive impurity is doped on the semiconductor 135 by using the gate electrode 155 as a mask to form the source region 1356, the drain region 1357, and the channel region1355. The conductive impurity may be a P-type semiconductor material such as indium (In), aluminum (Al), boron (B), and gallium (Ga), or an N-type semiconductor material such as phosphorus (P), arsenic (As), and antimony (Sb).

Thereafter, an activation process is performed at a temperature of about 450 °C for about 1 hour to activate the conductive impurity.

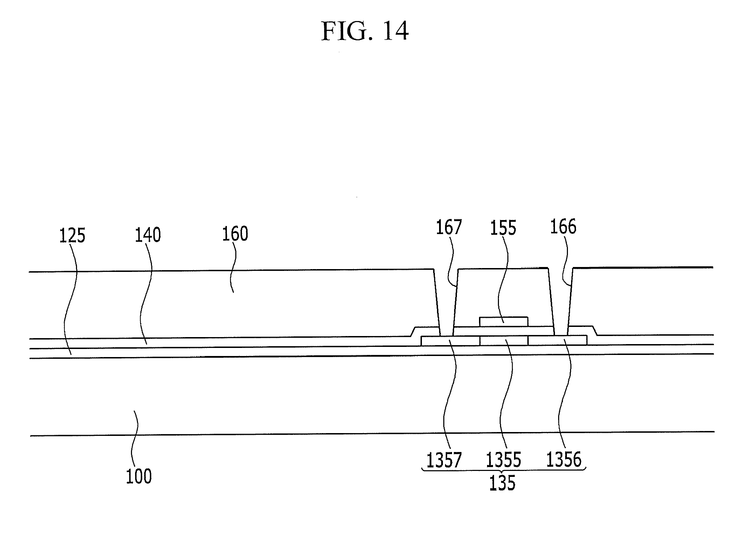

Next, as shown in FIG. 14, after the first interlayer insulating layer 160 is formed on the gate electrode 155, the contact holes 166 and 167 are formed to expose the source region and the drain region.

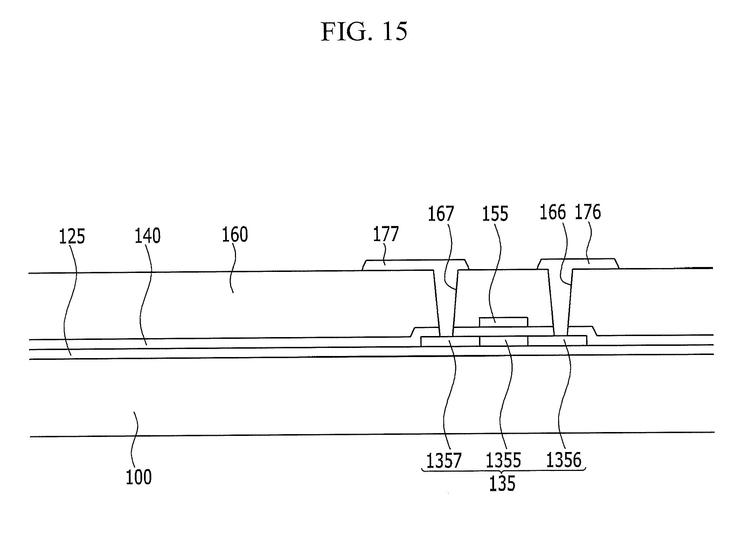

Next, as shown in FIG. 15, the metal film is formed on the first interlayer insulating layer 160 and then patterned to form the source electrode 176 and the drain electrode 177 connected to the source region and the drain region through the contact holes 166 and 167.

Thereafter, heat treatment is performed at about 350 °C for about 30 min. In this case, hydrogen passivation is performed over the polysilicon film due to hydrogen of the interlayer insulating layer.

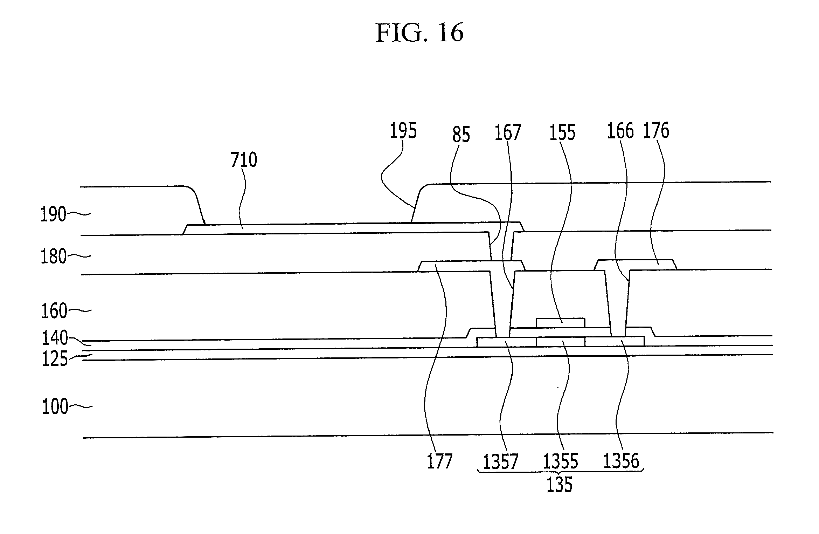

Next, as shown in FIG. 16, the second interlayer insulating layer 180 is formed on the source electrode and the drain electrode, and ITO/Ag/ITO are deposited on the second interlayer insulating layer and then patterned to form the first electrode 710.

In addition, the pixel definition layer 190 having the opening 195 through which the first electrode 710 is exposed is formed on the first electrode 710.

Next, as shown in FIG. 11, the organic emission layer 720 is formed in the opening 195, and the second electrode 730 is formed on the organic emission layer 720.

As shown in FIG. 4, an encapsulation member 130 is formed on the pixel. FIG. 4 shows the organic light emitting display panel including the pixel 120 as one layer.

The encapsulation member 130 may be formed of a plurality of layers, and may include at least one of an inorganic film and an organic film. The inorganic film and the organic film may be alternately, repeatedly laminated. The inorganic film may include an aluminum oxide or a silicon oxide. The organic film may include epoxy, acrylate, or urethane acrylate.

The inorganic film prevents external moisture and oxygen from permeating into the light emitting element. The organic film serves to reduce internal stress of the inorganic film or fill fine cracks and/or pinholes of the inorganic film. The inorganic film and the organic film are not limited thereto, and various kinds of inorganic films and organic films may be used.

The encapsulation member 130 covers the pixel 120 to prevent the organic light emitting diode from being exposed to the outside.

A barrier film (not shown) may be positioned between the organic light emitting substrate 200 including the pixel 120 and the thin film substrate 100. The barrier film blocks an inflow of unnecessary components such as moisture or oxygen from the outside into the pixel 120. The barrier film may include at least one of the organic film and the inorganic film, and the organic film and the inorganic film may be alternately, repeatedly laminated.

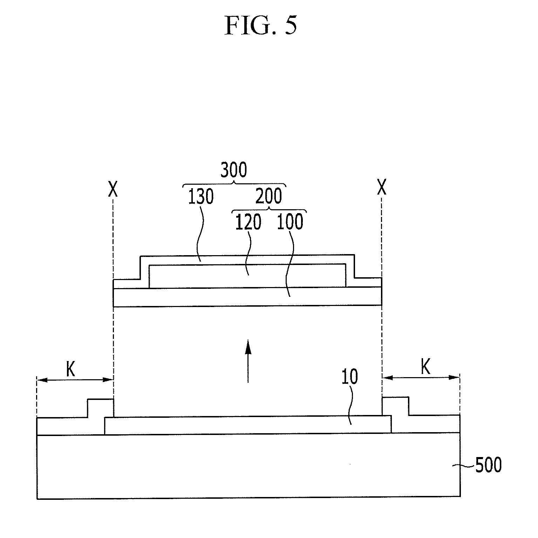

Thereafter, as shown in FIG. 5, the encapsulation member and the thin film substrate are cut by using a laser or wheel scribing process. The display panel 300 including the thin film substrate 100 is separated from the support substrate 500. Meanwhile, as shown in FIG. 8, when a plurality of release layers are formed on the thin film substrate, a plurality of display panels are separated.

In this case, the thin film substrate of a region K disposed on the support substrate are strongly bonded to the support substrate 500. Accordingly, the cut is made along a perimeter of a region where the release layer 10 is interposed between the thin film substrate 100 and the support substrate 500. For example, the cut is made along X in FIG. 4.

Without irradiating a laser on the thin film substrate 100 to separate the support substrate 100 from the support substrate 500, the thin film substrate 100 may be separated from the support substrate 500.

The release layer 10 is formed only on a portion corresponding to the display panel. For example, the release layer 10 is not formed between the adjacent display panels. In this way, the thin film substrate 100 and the support substrate 500 are in contact with each other on a portion where the release layer is not formed, thereby the thin film substrate 100 and the support substrate 500 strongly being bonded to each other.

The thin film substrate 100 and the support substrate 500 are not separated even during a high temperature process. A process for forming the thin film transistor of the pixel may include high temperature processes at least 300 °C or more, such as a dehydrogenation process, a conductive impurity activation process, and a crystallization process, several times. The thin film substrate 100 is not separated from the support substrate 500 in such high temperature processes.

Accordingly, the display panel may be manufactured without stripping of the thin film substrate and the support substrate during the process, and the release layer is positioned beneath the display panel when each display panel is separated. Therefore, the support substrate 500 and the thin film substrate 100 of the display panel may be easily separated.

According to an embodiment of the invention, the separation of the thin film substrate 100 and the support substrate 500 may be separated from each other without using a laser ablation process. Therefore, the separation method according to an embodiment may avoid the reduction of transparency in the thin film substrate 100 due to a laser ablation.

While the present invention has been shown and described with reference to certain embodiments thereof, it will be apparent to those of ordinary skill in the art that various changes in form and detail may be made therein without departing from the scope of the present invention as defined by the following claims.

## Claims

1. A method for manufacturing a display panel, comprising:
forming a release layer on a support substrate;
forming a thin film substrate on the release layer and the support substrate;
forming a pixel and an encapsulation member on a part of the thin film substrate, the part of the thin film substrate being overlapped with the release layer; and
separating the part of the thin film substrate from the support substrate,
wherein the release layer includes siloxane and polyimide silane.

2. A method according to claim 1, wherein siloxane and polyimide silane are mixed at a ratio of from 8:2 to 98:2.

3. A method according to claim 2, wherein the siloxane includes glassy silicone.

4. A method according to any preceding claim, wherein the forming of the pixel includes:
forming an amorphous silicon film on the thin film substrate;
forming a polysilicon film by crystallizing the amorphous silicon film;
forming a semiconductor by patterning the polysilicon film;
forming a gate insulating layer on the semiconductor;'
forming a gate electrode on the gate insulating layer;
forming a source region and a drain region by using the gate electrode as a mask to dope the semiconductor with a conductive impurity;
forming an interlayer insulating layer on the gate electrode, the interlayer insulating layer having contact holes exposing the source region and the drain region; and
forming a source electrode and a drain electrode connected through the contact holes to the source region and the drain region, respectively, on the interlayer insulating layer.

5. A method according to claim 4, wherein the forming of the source region and the drain region includes
activating the conductive impurity,
wherein the activating of the conductive impurity is performed at a temperature of 300 °C or more.

6. A method according to claim 5, wherein the activating of the conductive impurity is performed at a temperature of 450 °C for 1 hour.

7. A method according to claim 4, 5 or 6, wherein the forming of the pixel further includes forming an organic light emitting diode connected to the drain electrode.

8. A method according to any preceding claim, wherein
the thin film substrate is in contact with the release layer and the support substrate, wherein adherence between the thin film substrate and the support substrate is greater than adherence between the thin film substrate and the release layer.

9. A method according to claim 8, wherein the part of the thin film substrate is defined by a perimeter of a region where the release layer is interposed between the thin film substrate and the support substrate, wherein the separating of the part of the thin film substrate is performed by cutting the part of the thin fim substrate along the perimeter.

10. A method according to any preceding claim, wherein the thin film substrate includes at least one of a polymer substrate and an ultra-thin film glass substrate, the polymer substrate including at least one of polyimide, polycarbonate, polyacrylate, polyetherimide, polyethersulfone, polyethylene terephthalate, and polyethylene naphthalate.

11. A method according to claim 10, wherein the ultra-thin film glass substrate has a thickness of from 50 µm to 200 µm.

12. A method of manufacturing a display panel according to any preceding claim, the said method comprising:
forming a plurality of release layers on a support substrate in a matrix form;
forming a thin film substrate on the support substrate, covering the pluarlity of release layers, the thin film substrate being in contact with the plurality of release layers and the support substrate;
forming a plurality of pixels on the thin film substrate, each pixel being disposed on a part of the thin film substrate, the part of the thin film substrate being overlapped with each release layer;
cutting each pixel along a perimeter of a region where each release layer is interposed between the thin film substrate and the support substrate; and
separating each pixel from the support substrate to form a display panel,
wherein each release layer includes siloxane and polyimide silane.
